# EUROPÄISCHE PATENTSCHRIFT

(11) **EP 3 909 106 B1**
(45) Veröffentlichungstag und Bekanntmachung des Hinweises auf die Patenterteilung: **19.11.2025**
(21) Anmeldenummer: 20718166.0
(22) Anmeldetag: 24.03.2020
(51) Int. Cl.: H02J 1/08, H02H 7/26, H02J 13/00, H01H 85/30, H01H 85/02

(54) **SICHERE FEHLERERKENNUNG UND FEHLERLOKALISIERUNG IN EINER LASTZONE EINES DC NETZES**
DÉTECTION D'ERREUR ET LOCALISATION D'ERREUR DANS UNE ZONE DE CHARGE D'UN RÉSEAU CC
ERROR DETECTION AND ERROR LOCATION IN A LOAD ZONE OF A DC NETWORK

(30) Priorität: 30.04.2019 EP 19171874
(43) Veröffentlichungstag der Anmeldung: 17.11.2021
(73) Patentinhaber: Siemens Aktiengesellschaft, 80333 München (DE)
(72) Erfinder: FRÜHAUF, Markus, 91080 Uttenreuth (DE); WEIS, Benno, 91334 Hemhofen (DE)
(74) Vertreter: Siemens Patent Attorneys
(86) Internationale Anmeldenummer: PCT/EP2020/058084
(87) Internationale Veröffentlichungsnummer: WO 2020/221514

(56) Entgegenhaltungen:
- EP-A1- 3 098 921
- DE-A1- 102014 014 469
- DE-C1- 4 142 760

## Beschreibung

Die Erfindung betrifft eine Lastzone mit den Merkmalen des Oberbegriffs des Anspruchs 1. Die Erfindung betrifft weiter ein DC-Netz mit einer derartigen Lastzone und einer Energiequelle, wobei die Energiequelle derart mit der Lastzone verbunden ist, dass die elektrischen Geräte mit elektrischer Energie aus der Energiequelle versorgbar sind. Ferner betrifft die Erfindung ein Verfahren zur Fehlerloklisierung in einer derartigen Lastzone oder eines derartigen DC-Netzes.

Elektrische Netze sind heutzutage nicht mehr ausschließlich als Wechselspannungsnetze ausgebildet. Immer häufiger werden elektrische Netze als Gleichspannungsnetze, auch als DC Netze bezeichnet, ausgeführt. Dabei werden verschiedene elektrische Geräte parallel an einem DC-Bus angeordnet. Bei dem DC-Bus handelt es sich um mindestens zwei elektrische Leiter, zwischen denen eine Gleichspannung anliegt. Diese versorgen dann die parallel angeordneten elektrischen Geräte mit elektrischer Energie. Bei den elektrischen Geräten kann es sich um elektrische Verbraucher oder Energiespeicher handeln. Die elektrischen Verbraucher können dabei auch rückspeisefähige Verbraucher sein, die gespeicherte Energie in den DC-Bus einspeisen können. Bei der gespeicherten Energie kann es sich um einen geladenen Kondensator oder eine stromdurchflossene Spule handeln. Ebenso ist die Rückspeisung von Bewegungs- oder Rotationsenergie eines Antriebssystems möglich. Auch ein solches Antriebssystem kann ein elektrisches Gerät darstellen.

Oftmals werden dabei mehrere elektrische Geräte zu einer sogenannten Lastzone zusammengefasst. Am Eingang einer solchen Lastzone befindet sich ein elektronischer Schalter. Mit diesem elektronischen Schalter kann die Lastzone von einer Energiequelle oder mehreren Energiequellen, insbesondere einer Spannungsquelle, getrennt werden, welche die Lastzone mit elektrischer Energie versorgt. Dieses Trennen kann beispielsweise im Fehlerfall wie beispielsweise einem Kurzschluss geschehen, um die elektrischen Verbraucher der Lastzone oder auch die anderen Komponenten des DC Netzes außerhalb der Lastzone zu schützen. Dadurch werden gerade die Rückwirkungen des Fehlers auf andere Lastzonen des DC-Netzes zuverlässig verhindert. Insbesondere kann der elektronische Schalter mit seiner Steuerung oder Logik einen Kurzschluss in der Lastzone schnell und zuverlässig erkennen und zum Schutz des DC Netzes diese Lastzone von der Energiequelle trennen. Dabei unterbricht der elektronische Schalter den Strom, den sogenannten Netzstrom, der von der Energiequelle in die Lastzone fließt. In die Fehlerstelle kann dann nur noch die Summe des Stroms aus den benachbarten, parallel angeordneten elektrischen Geräten fließen.

Durch den Einsatz des elektronischen Schalters kann das Trennen von der Energiequelle schnell und ohne Lichtbogen erfolgen. Dies ermöglicht einen sicheren Betrieb selbst bei niederinduktiven Netzen mit hohen Stromanstiegsgeschwindigkeiten bei Fehlerfällen wie einem Kurzschluss. Da dieser elektronische Schalter vergleichsweise teuer ist, wird er nicht zum Schutz an jedem elektrischen Gerät eingesetzt, sondern nur vor einer Parallelschaltung von mehreren Geräten, die eine Lastzone bilden.

Mit Hilfe des elektronischen Schalters ist es möglich, die Auswirkungen eines Fehlers auf die entsprechende Lastzone zu beschränken.

Aus der EP 3 098 921 A1 ist ein System, ein Verfahren, eine Technik und eine Vorrichtung zur Fehlerortung in DC-Leistungsverteilungssystemen bekannt. Eine Ausführungsform betrifft ein DC-Leistungsverteilungssystem mit mehreren Zonen, die jeweils eine DC-Leistungsverteilungsleitung und eine Schutzvorrichtung umfassen. Jede Schutzvorrichtung ist so aufgebaut, dass sie eine oder mehrere elektrische Eigenschaften einer Leitung erfasst und einen Stromkreis, der die Leitung enthält, steuerbar öffnet. Mindestens ein intelligentes elektronisches Gerät ist strukturiert, um eine Leitungsinduktivität basierend auf elektrischen Eigenschaften zu bestimmen, die von einer oder mehreren der Schutzvorrichtungen erfasst werden, und um einen Ort des Leitungsfehlers basierend auf der bestimmten Leitungsinduktivität zu bewerten.

Aus der DE 10 2014 014 469 A1 ist eine Schaltungsanordnung zur Erkennung eines nicht funktionsgemäßen Ausfalls einer ersten Sicherungseinrichtung bekannt, wobei die Schaltungsanordnung mit einer Energiequelle und einem Verbraucher koppelbar ist und die Schaltungsanordnung die erste Sicherungseinrichtung, die dazu ausgelegt ist, im Auslösefall der ersten Sicherungseinrichtung einen durch sie hindurch fließenden Strom zu unterbrechen, und eine Sensoreinrichtung aufweist, die dazu ausgelegt ist, den Auslösefall der ersten Sicherungseinrichtung zu detektieren. Dabei weist die Schaltungsanordnung eine zweite Sicherungseinrichtung auf, die parallel zur ersten Sicherungseinrichtung geschaltet ist, wobei die Sensoreinrichtung dazu ausgelegt ist, einen Auslösefall der zweiten Sicherungseinrichtung zu detektieren.

Aus der DE 41 42 760 C1 ist eine Lastkreisüberwachungsanordnung bekannt. Diese enthält in den Zuleitungen zu mindestens einem Verbraucher einen Messwiderstand. Der Widerstandseingang ist über einen Potentialteiler mit dem einen Komparatoreingang und sein Ausgang mit dem anderen Komparatoreingang verbunden. Der Komparator steuert eine Warneinrichtung an. Als Messwiderstand kann die Sicherung in der Zuleitung zum Verbraucher verwendet werden. Zur Funktionsüberwachung der Last wird die Ansprechschwelle des Komparators an den Laststrom und den Widerstandsverlauf der Sicherung mit der Temperatur angepasst.

Der Erfindung liegt die Aufgabe zugrunde, eine Lastzone eines DC-Netzes im Hinblick auf die Fehlererkennung und Fehlerlokalisierung, wie beispielsweise bei Auftreten eines Kurzschlusses, zu verbessern.

Diese Aufgabe wird durch eine Lastzone mit den Merkmalen des Anspruchs 1 gelöst. Weiter wird diese Aufgabe durch ein DC-Netz mit einer derartigen Lastzone und mindestens einer Energiequelle gelöst, wobei die Energiequelle mit dem Anschluss der Lastzone verbunden ist, insbesondere derart mit der Lastzone verbunden ist, dass die elektrischen Geräte mit elektrischer Energie aus der Energiequelle versorgbar sind und dass mittels des elektronischen Schalters die elektrische Verbindung zwischen der Energiequelle und dem DC-Bus unterbrechbar ist. Ferner wird diese Aufgabe durch Verfahren mit den Merkmalen des Anspruchs 6 gelöst.

Weitere vorteilhafte Ausgestaltungen der Erfindung sind in den abhängigen Ansprüchen angegeben.

Der Erfindung liegt die Erkenntnis zugrunde, dass ein fehlerhaftes Gerät unter den elektrischen Geräten dadurch erkannt und/oder ermittelt werden kann, dass die jeweiligen Spannungen über den Sicherungen der Lastzone mittels des jeweiligen Spannungssensors gemessen werden. Die elektrischen Geräte werden oftmals auch als Verbraucher oder Last bezeichnet. Diese elektrischen Verbraucher oder Lasten können auch rückspeisefähig sein. Das Erkennen des fehlerhaften Gerätes innerhalb der Lastzone wird auch als Fehlerlokalisierung bezeichnet.

Als Lastzone wird eine Anordnung mit einer Vielzahl von, das heißt mindestens zwei, elektrischen Geräten bezeichnet, die über einen DC-Bus und einem elektronischen Schalter mit elektrischer Energie versorgt werden. Der DC-Bus und der elektronische Schalter sind dabei Teil der entsprechenden Lastzone. Die elektrischen Geräte einer Lastzone sind gemeinsam mit dem elektronischen Schalter von einer Energiequelle oder mehreren Energiequellen trennbar.

Sofern eine der Sicherungen ausgelöst hat, d.h. die leitende Verbindung zwischen den Anschlüssen dieser Sicherung unterbrochen ist, ist das fehlerhafte Gerät auf einfache Weise erkennbar, da es sich um das elektrische Gerät handelt, dass über diese ausgelöste Sicherung mit dem DC Bus verbunden ist. Allerdings kann das Problem auftreten, dass bei einem Kurzschluss in einem elektrischen Gerät eventuell dessen Sicherung nicht schnell genug auslöst, sondern der elektronische Schalter der Lastzone derart schnell die Verbindung zur Energiequelle, insbesondere zu einer Spannungsquelle, unterbricht, dass keine erforderliche Energie zur Auslösung der Sicherung mehr vorhanden ist. In diesem Fall ist es nicht möglich, anhand des Zustands der Sicherungen zu erkennen, in welchem elektrischen Gerät der Lastzone der Fehler aufgetreten ist.

Damit ist es als Vorteil zu sehen, dass auch vor dem Auslösen der Sicherung ein Fehler derart schnell erkannt wird, dass ein Auslösen der Sicherung nicht mehr erforderlich ist, sondern andere Schutzmaßnahmen wie beispielsweise das Öffnen des elektronischen Schalters zum Tragen kommen können. Da keine Sicherung ausgelöst hat, ist die Ermittlung des fehlerhaften Gerätes schwierig. Durch Anwendung des erfindungsgemäßen Verfahrens kann allerdings auch in diesem Fall das fehlerhafte Gerät zuverlässig erkannt werden.

Erfindungsgemäß wird das fehlerhafte Gerät jedoch anhand der durch den Spannungssensor gemessenen Spannung, die über der Sicherung anliegt, ermittelt. Wenn ein Fehler in einem der elektrischen Geräte vorliegt und der elektronische Schalter die Verbindung zur Energiequelle unterbrochen hat, kann ein Energieaustausch nur noch zwischen den elektrischen Geräten der Lastzone erfolgen. Dabei fließt der Strom, betrachtet man das positive Potential des DC-Busses, von den nicht fehlerhaften Geräten in das fehlerhafte Gerät. Die Richtung des Stromflusses kann auch anhand der über den Sicherungen gemessenen Spannungen anhand der Polarität der Spannung über der Sicherung erkannt werden. Damit lässt sich dann das fehlerhafte Gerät erkennen, da es eine Spannung über der Sicherung verursacht, die sich aufgrund des Stromflusses durch den Widerstand der Sicherung ergibt. Bei denjenigen elektrischen Geräten, die Energie abgeben, kann davon ausgegangen werden, dass diese nicht defekt sind.

Die Sicherung ist meist in der Verbindung zwischen dem elektrischen Gerät und dem positiven Potential des DC-Busses angeordnet. Genauso ist es aber alternativ oder ergänzend möglich, diese Sicherung oder eine weitere zusätzliche Sicherung in der Verbindung zum negativen Potential des DC Busses anzuordnen. In diesem Fall fließt der Strom aus dem fehlerhaften Gerät heraus.

Somit kann im Fehlerfall, insbesondere nachdem aufgrund des Fehlers der elektronische Schalter bereits geöffnet hat, das fehlerhafte Gerät mit Hilfe der Spannungssensoren bestimmt werden, welche jeweils die Spannung über der Sicherung messen. Dies kann auf einfache Weise beispielsweise anhand der Polaritäten der Spannungen und damit der Kenntnis der Stromflussrichtungen erfolgen.

Der Wert des Widerstands der einzelnen Sicherungen ist einer hohen Streuung unterworfen. Damit ist es auch schwierig, der gemessenen Spannung einen Stromwert zuzuordnen. Es hat sich gezeigt, dass für das Verfahren allerdings die Polarität der Spannung hinreichend Aufschluss darüber gibt, bei welchem elektrischen Gerät der Fehler vorliegt. Somit kann auch unabhängig von der Streuung der Widerstandswerte zuverlässig der Fehlerort bestimmt werden.

Alternativ oder ergänzend ist es auch möglich, die Spannungshöhe der gemessenen Werte der jeweiligen Spannungssensoren für die Bestimmung des fehlerhaften Gerätes heranzuziehen. Dabei kann davon ausgegangen werden, dass der Strom in das fehlerhafte Gerät aufgrund des Fehlers, wie beispielsweise einem Kurzschluss, hohe Werte, insbesondere einen derart hohen Wert, der sich um mindestens eine Größenordnung von einem betrieblich auftretenden Strom unterscheidet, annimmt und/ oder eine große Spannungsänderung aufweist. Sowohl ein entsprechend hoher Stromwert als auch eine entsprechend hohe Änderungsgeschwindigkeit des Stroms kann mittels des Spannungssensors in der Spannung über der jeweiligen Sicherung zuverlässig erkannt werden. Der relativ ungenaue Zusammenhang zwischen der Stromstärke und der gemessenen Spannung, die sich aufgrund der großen Streuung der Widerstandswerte der Sicherung ergibt, wirkt sich auch hier nicht störend aus, da lediglich ein Fehlerstrom von einem betriebsmäßig vorkommenden Strom unterschieden werden muss. Es hat sich gezeigt, dass dies auch bei entsprechender Streuung der Widerstandswerte der Sicherungen zuverlässig möglich ist.

Besonders vorteilhaft ist, dass der Widerstand der Sicherung mit zunehmender Temperatur steigt. Ein Fehlerstrom stellt einen besonders hohen Strom dar und führ schnell zu einer Erwärmung der Sicherung. Das erhöht damit auch den Spannungsabfall an der Sicherung im Fehlerfall. Zumindest ist dieser Fehlerstrom deutlich größer als ein im normalen Betrieb vorkommender Strom. Damit erzeugt ein Fehlerstrom durch die Erwärmung der Sicherung einen überproportional hohen Spannungsabfall über der Sicherung. Damit ist der Fehlerstrom besonders zuverlässig detektierbar.

Weiterhin ist es bei dieser Anwendung besonders vorteilhaft, dass auf die Verwendung eines Stromwandlers verzichtet werden kann. Auch ohne Stromwandler kann der Fehler zuverlässig in einem der elektrischen Geräte zuverlässig lokalisiert werden.

Der vorgegebene Grenzwert kann dabei je nach Charakter des elektrischen Gerätes, also beispielsweise bei rückspeisefähigen elektrischen Geräten, auch vorzeichenabhängig sein. Das bedeutet, dass ein Auslösen des Schalters bei einer ersten Spannungsrichtung einen anderen Grenzwert aufweist als bei einer der ersten Spannungsrichtung entgegengesetzten Polarität. Somit können abhängig vom Betriebszustand des elektrischen Gerätes, die Schutzmaßnahme durch Öffnen des Schalters eingeleitet werden.

Bei einer vorteilhaften Ausgestaltung der Erfindung ist die die Verbindung zwischen DC-Bus und jeweiligem elektrischen Gerät stromwandlerfrei ausgeführt. Stromwandlerfrei heißt, dass in dieser Verbindung zwischen DC-Bus und jeweiligem elektrischen Gerät kein Stromwandler angeordnet ist. Da auf den Stromwandler für die Erkennung bzw. Lokalisierung des Fehlers verzichtet werden kann, können die einzelnen Stränge vom DC-Bus, an denen die elektrischen Geräte angeschlossen sind, besonders kostengünstig ausgeführt werden, da kein Stromwandler benötigt wird. Darüber hinaus entstehen durch den Stromwandler auch keine Verluste, wie sie beispielsweise bei der Verwendung eines Messshunts entstehen würden. Diese stromwandlerfreie Anordnung macht die Lastzone besonders kostengünstig und verlustarm. Damit kann eine besonders wirtschaftliche Lösung mit hohem Wirkungsgrad bereitgestellt werden.

Bei einer weiteren vorteilhaften Ausgestaltung der Erfindung wird das elektrische Gerät mit der höchsten, durch den Spannungssensor gemessenen Spannung als fehlerhaftes Gerät ermittelt. Neben der Betrachtung der Polaritäten der Spannungen hat es sich als vorteilhaft erwiesen, auch die Spannungshöhe zu berücksichtigen. Es kann sich ergeben, dass auch ein fehlerfreies Gerät keine Energie in das fehlerhafte Gerät ein- bzw. zurückspeist. Dies ist beispielsweise dann der Fall, wenn das fehlerfreie Gerät keinen Energiespeicher aufweist. So kann zum Beispiel ein rein ohmscher Verbraucher, wie etwa eine Heizung, keine Energie in den fehlerhaften Verbraucher einspeisen. Ebenso kann ein induktiver Verbraucher auch bei einem Fehler eines anderen elektrischen Gerätes der Lastzone weiterhin Energie aus dem DC-Bus aufnehmen. So ist eine Vielzahl von elektrischen Verbrauchern denkbar, die keine Energie in den fehlerhaften Verbraucher einspeisen. Es ist wie am Beispiel des induktiven, elektrischen Gerätes erläutert, auch möglich, dass diese auch Energie von den übrigen fehlerfreien Verbrauchern noch aufnehmen. In diesem Fall ist es vorteilhaft, nicht nur die Polaritäten der gemessenen Spannungen auszuwerten, sondern auch die Spannungshöhe. Es kann dabei davon ausgegangen werden, dass in dem elektrischen Gerät, in dessen Verbindung zum DC-Bus an der Sicherung die höchste Spannung durch den Spannungssensor gemessen wird oder gemessen wurde, der Fehler vorliegt. Somit handelt es sich bei dem elektrischen Gerät mit der höchsten durch den Spannungssensor gemessenen Spannung um das fehlerhafte Gerät.

Dabei ist die Spannung des Spannungssensors positiv, wenn der Strang mit dem betreffenden elektrischen Gerät elektrische Energie aufnimmt. Entsprechend ist die Spannung am Spannungssensor negativ, wenn der entsprechende Strang mit seinem elektrischen Verbraucher Energie an den DC-Bus abgibt.

Bei einer weiteren vorteilhaften Ausgestaltung der Erfindung wird das fehlerhafte Gerät dadurch erkannt, dass die durch den Spannungssensor gemessenen Spannung einen vorgebbaren Grenzwert überschreitet. Unabhängig davon, ob der elektronische Schalter geschlossen oder beispielsweise aufgrund eines Fehlers in der Lastzone bereits geöffnet ist, kann ein Fehler in einem elektrischen Gerät der Lastzone dadurch erkannt und lokalisiert werden, dass die durch den Spannungssensor gemessene Spannung mit einem vorgebbaren Grenzwert verglichen wird. Überschreitet diese Spannung den Grenzwert, kann davon ausgegangen werden, dass bei dem betreffenden elektrischen Gerät ein Fehler vorliegt. Besonders vorteilhaft ist es, wenn der Grenzwert um mindestens eine Größenordnung größer ist als eine Spannung, die sich unabhängig vom Widerstand der Sicherung bei einem betrieblich auftretenden Strom durch die Sicherung ergibt. Unabhängig vom Widerstandswert bedeutet in diesem Zusammenhang, dass der Grenzwert im Rahmen einer worst case Betrachtung des Widertands der Sicherung bestimmt wird. Sofern der elektronische Schalter noch geschlossen ist, kann dieses Überschreiten des Grenzwertes auch als Kriterium zum Öffnen des elektronischen Schalters verwendet werden.

Im Gegensatz zum Auslösen der Sicherung wird nur ein kurzzeitiges Überschreiten des Grenzwertes durch die gemessene Spannung benötigt, um einen Fehler nicht nur zuverlässig erkennen und lokalisieren zu können, sondern auch eine Schutzreaktion, wie beispielsweise das Öffnen des elektronischen Schalters auslösen zu können.

Auch hier ist die Spannung des Spannungssensors positiv, wenn der Strang mit dem betreffenden elektrischen Gerät elektrische Energie aufnimmt. Entsprechend ist die Spannung am Spannungssensor negativ, wenn der entsprechende Strang mit seinem elektrischen Verbraucher Energie an den DC-Bus abgibt. Wird der Spannungssensor mit anderer Polarität betrieben, d.h., wenn eine in den Strang fließende elektrische Energie eine negative Spannung über der Sicherung verursacht, wird das fehlerhafte Gerät dadurch erkannt, dass die durch den Spannungssensor gemessenen Spannung einen vorgebbaren negativen Grenzwert unterschreitet.

Bei einer weiteren vorteilhaften Ausgestaltung der Erfindung wird bei oder nach Auftreten eines Fehlers in der Lastzone das fehlerhafte Gerät ermittelt, wobei der Spitzenwert, der über der Sicherung anliegenden Spannung jeweils als Datenwert erfasst und gespeichert wird und für die Ermittlung des fehlerhaften Gerätes herangezogen wird. Bei einer entsprechenden Lastzone ist dabei ein Spitzenwert, der über der Sicherung anliegenden Spannung, insbesondere mittels eines zwischen der Sicherung und dem Spannungssensor angeordneten Spitzenwertgleichrichters, jeweils als Datenwert erfassbar und speicherbar. Für die Ermittlung des fehlerhaften Gerätes ist in erster Linie der Spitzenwert der auftretenden Spannung entscheidend. An diesem ist erkennbar, dass auch ein entsprechender Spitzenwert eines Stroms in das entsprechende elektrische Gerät vorhanden sein musste. Somit kann anstelle des Messwertes zur Ermittlung des fehlerhaften Gerätes der entsprechende Spitzenwert herangezogen werden. Auch mit diesem Spitzenwert kann der entsprechend höchste Spitzenwert aller gemessenen Spannungen herangezogen werden, um das fehlerhafte Gerät zu ermitteln. Auch kann der Datenwert mit einem vorgebbaren Grenzwert verglichen werden und bei Überschreiten des Grenzwertes ein Fehler in der Lastzone erkannt werden. Der Fehler liegt in dem elektrischen Gerät vor, in dessen Strang die Spannung an der Sicherung den vorgebaren Grenzwert überschritten hat.

Die Speicherung kann beispielsweise durch Speicherung der Spannung in einer Datenverarbeitung erfolgen. Alternativ ist es möglich, den Spannungswert mit Hilfe eines Spitzenwertgleichrichters, der am Ausgang einen Kondensator aufweist, zu speichern. Dabei hält der Kondensator an seinen beiden Anschlüssen die Spannung des aufgetretenen Spitzenwertes.

Besonders vorteilhaft bei dieser Ausgestaltung ist, dass auch nach Auftreten des Fehlers auf besonders einfache Weise das fehlerhafte Gerät erkannt werden kann. Dies liegt daran, dass der Spitzenwert entsprechend gespeichert ist. Diese Speicherung kann, wie oben bereits erläutert, auf analoge Weise durch eine Spannung am Kondensator eines Spitzenwertgleichrichters oder innerhalb der Datenverarbeitung, bei dem ein entsprechender Spannungswert als Datenwert gespeichert wurde, erfolgen.

Vorteilhaft bei dieser Ausgestaltungsform ist, dass das Verfahren zum Betreiben der Lastzone nicht kontinuierlich ausgeführt werden muss, sondern erst bei Vorliegen eines Fehlers in der Lastzone. Dies spart Rechenzeit und Rechenleistung in der Steuerung bzw. Regelung der Lastzone.

Bei einer weiteren vorteilhaften Ausgestaltung der Erfindung wird bei einer negativen über der Sicherung anliegenden Spannung der gespeicherte Datenwert reduziert, insbesondere zurückgesetzt. Bei einer entsprechenden Lastzone ist bei Auftreten einer negativen über der Sicherung anliegenden Spannung der jeweilige gespeicherte Datenwert reduzierbar, insbesondere rücksetzbar. Eine negative Spannung liegt in erster Linie dann über der Sicherung an, wenn der entsprechende elektrische Verbraucher elektrische Energie abgibt. Damit ist davon auszugehen, dass an diesem elektrischen Verbraucher kein Fehler vorliegt. Es hat sich daher als vorteilhaft erwiesen, diesen Zustand der erfassten negativen Spannung dahingehend zu berücksichtigen, dass der gespeicherte Datenwert für den Spitzenwert reduziert oder sogar komplett zurückgesetzt, d.h. auf Null gesetzt wird. Dies kann dadurch geschehen, dass der Kondensator am Ausgang eines Spitzenwertgleichrichters entladen bzw. für das Rücksetzen vollständig entladen wird. Alternativ kann dies auch dadurch geschehen, dass der gespeicherte Datenwert durch einen neuen kleineren Wert bzw. durch den Wert Null in der Datenverarbeitung überschrieben wird. Durch dieses Vorgehen werden die Unterschiede in den gespeicherten Datenwerten der jeweiligen Spannungssensoren vergrößert, weil an den rückspeisenden, nicht fehlerbehafteten Geräten im Fehlerfall, wie beispielsweise einem Kurzschluss, eine negative Spannung auftritt. Bei dem fehlerbehafteten Gerät tritt jedoch eine positive Spannung. Diese positive Spannung lässt sich durch dieses Ausführungsbeispiel besonders einfach und zuverlässig erkennen. Damit wird die Zuverlässigkeit der Fehlerlokalisierung weiter erhöht.

Bei einer weiteren vorteilhaften Ausgestaltung der Erfindung wird als gespeicherter Datenwert der positive Spitzenwert erfasst und gespeichert, wobei ein weiterer Datenwert erfasst und gespeichert wird, der jeweils dem negativen Spitzenwert der über der Sicherung anliegenden Spannung entspricht. Bei dieser Ausgestaltung kann darauf verzichtet werden, eine entsprechende Reduzierung oder Zurücksetzung der Datenwerte vorzunehmen. Für jeden Spannungssensor wird dabei der maximale positive Wert als positiver Spitzenwert erfasst und gespeichert. Darüber hinaus wird als weiterer Datenwert der minimalste negative Wert erfasst und gespeichert. Dieser wird als negativer Spitzenwert bezeichnet. Für jeden elektrischen Verbraucher ist damit auf einfache Weise zu erkennen, ob er zum Zeitpunkt des Fehlers elektrische Energie aufgenommen oder in den DC-Bus eingespeist hat. Dies kann dadurch erkannt werden, welcher der beiden Spitzenwerte, der positive Spitzenwert oder der negative Spitzenwert größer ist. Ist der positive Spitzenwert größer, kann davon ausgegangen werden, dass elektrische Energie aus dem DC-Bus aufgenommen wurde. Ist jedoch der negative Spitzenwert größer, kann davon ausgegangen werden, dass elektrische Energie in Richtung des DC-Busses abgegeben wurde. Damit steht neben dem Kriterium des größten positiven Spitzenwerts zur Ermittlung des fehlerhaften Gerätes ein weiteres Kriterium zur Verfügung. Dabei kommen in erster Linie die elektrischen Geräte, bei denen der positive Spitzenwert, d.h. der gespeicherte Datenwert, größer ist als der negative Spitzenwert, also der weitere Datenwert, als elektrisches Gerät in Frage, bei dem ein Fehler vorliegen kann. Im Anschluss kann dann untersucht werden, welcher der in Frage kommenden elektrischen Geräte den höchsten positiven Spitzenwert erfasst hat. Durch dieses doppelte Kriterium kann ein fehlerhaftes Gerät besonders zuverlässig erkannt werden.

Bei einer weiteren vorteilhaften Ausgestaltung der Erfindung wird der Zeitpunkt des Auftretens des gespeicherten Datenwertes und/oder des gespeicherten weiteren Datenwertes erfasst und gespeichert, wobei die Erkennung des fehlerhaften Gerätes in Abhängigkeit von den Zeitpunkten der gespeicherten Datenwerten erfolgt. Durch die Kenntnis der Zeitpunkte, an denen der Spitzenwert aufgetreten ist, kann auf einfache Weise auf den Zustand der elektrischen Geräte zum Fehlerzeitpunkt in der Lastzone geschlossen werden. Der Zeitpunkt des Auftretens des Fehlers ist durch den größten Spannungswert bekannt, der durch einen der Spannungssensoren gemessen und als Datenwert gespeichert wurde. Nun kann der Zustand aller elektrischen Geräte anhand der gespeicherten Datenwerte bzw. der weiteren Datenwerte zu dem Zeitpunkt des Fehlers oder seiner unmittelbaren zeitlichen Umgebung, beispielsweise in der Größenordnung bis zu 10ms davor oder danach, bestimmt werden. Dabei wird bei jeder Auswerteeinheit die zeitliche Korrelation zwischen dem positiven und dem negativen Spitzenwert derart festgehalten, dass im Nachhinein erkennbar ist, welcher Wert zuerst aufgetreten ist. Durch diese zusätzliche Information können Fehlinterpretationen in Bezug auf die Fehleranalyse bei Umschwingvorgängen in ausgebreiteten DC-Abschnitten mit einem großen Leistungsspektrum am Verbraucher ausgeschlossen werden. Die Zuverlässigkeit bei der Ermittlung des Fehlers und des fehlerhaften Gerätes wird hierdurch weiter erhöht.

Bei einer weiteren vorteilhaften Ausgestaltung der Erfindung wird das Verfahren bei Vorliegen eines Fehlers in der Lastzone gestartet. Der Aufbau der Lastzone mit einem elektronischen Schalter und den mehreren, mindestens zwei, vorhandenen elektrischen Geräten, erlaubt es, das Verfahren zum Betreiben dieser Lastzone erst dann zu starten, wenn ein Fehler in der Lastzone vorliegt. Dabei kann der elektronische Schalter mit einer entsprechenden Auswerte- bzw. einer Regelungs- oder Steuerungsvorrichtung derart ausgebildet sein, einen Fehler in der Lastzone zu erkennen, und darauf entsprechend durch Öffnen des elektronischen Schalters zu reagieren. Die Ermittlung des fehlerhaften Gerätes unter den elektrischen Geräten der Lastzone kann im Anschluss mit dem Verfahren zum Betreiben der Lastzone durchgeführt werden. Sofern keine Messwerte der Spannungssensoren gespeichert werden, sollte das Verfahren möglichst schnell bei Vorliegen eines Fehlers in der Lastzone gestartet werden, damit die Spitzenwerte dem Verfahren noch zur Verfügung stehen. Allerdings können auch die Spannungen zur Ermittlung des fehlerhaften Gerätes herangezogen werden, die sich nach dem Öffnen des elektronischen Schalters einstellen. Auch mit diese Spannungswerten und/oder Datenwerten kann eine zuverlässige Ermittlung des fehlerhaften Gerätes erfolgen, wie oben bereits beschrieben. Gerade auch mit Speicherung der entsprechenden Messwerte des Spannungssensors lässt sich die Ermittlung des fehlerhaften Gerätes auf nahezu beliebige Zeitpunkte nach Auftreten des Fehlers und Öffnen des elektronischen Schalters verschieben. Dies liegt darin begründet, dass die Informationen, die zur Ermittlung des fehlerhaften Gerätes benötigt werden, dauerhaft bzw. zumindest hinreichend lange der entsprechenden Auswerteeinheit zur Verfügung stehen. Vorteilhaft bei diesem Verfahren, bei dem die Auswertung erst nach oder mit Vorliegen eines Fehlers in der Lastzone gestartet wird, besteht darin, dass keine großen Rechenkapazitäten für den Normalbetrieb benötigt werden. Erst bei Vorliegen eines Fehlers wird eine entsprechende Rechenkapazität und Verarbeitungskapazität der jeweiligen Messwerte der Spannungssensoren notwendig. Auf eine kontinuierliche Überwachung der Spannungen oder Strömen in der Lastzone kann verzichtet werden. Damit ist dieses Verfahren zur Ermittlung eines fehlerhaften Gerätes unter den elektrischen Geräten besonders einfach und resourcenschonend möglich.

Im Folgenden wird die Erfindung anhand der in den Figuren dargestellten Ausführungsbeispiele näher beschrieben und erläutert. Es zeigen:
- FIG 1: ein DC-Netz mit einer Lastzone, sowie
- FIG 2 bis FIG 5: Ausführungsbeispiele eines vorteilhaften Spitzenwertgleichrichters.

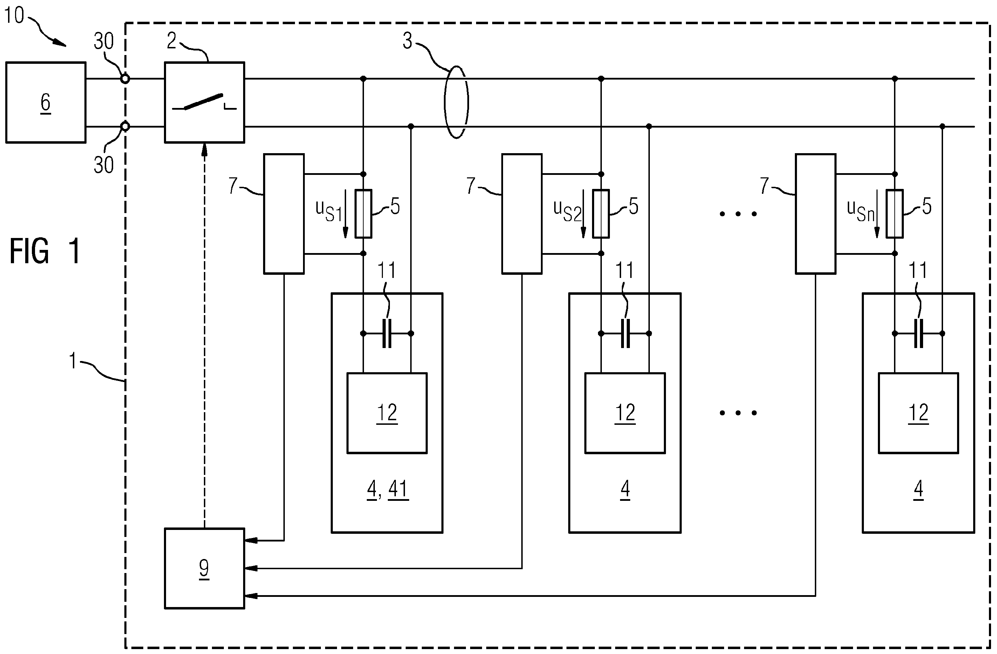

Die FIG 1 zeigt ein DC-Netz 10 mit einer Lastzone 1 und einer Energiequelle 6. Die Energiequelle 6 kann dabei beispielsweise als Spannungsquelle ausgeführt sein. Die Energiequelle 6 ist mit Anschlüssen 30 der Lastzone 1 verbunden und speist die elektrischen Geräte 4 der Lastzone 1 mit elektrischer Energie. Dazu ist in der Lastzone 1 ein DC-Bus 3 angeordnet, der die Spannung an die elektrischen Geräte 4 heranführt. Die elektrischen Geräte 4 sind dabei über eine elektrische Verbindung mit dem DC-Bus 3 verbunden. In dieser elektrischen Verbindung ist jeweils für jedes elektrische Gerät 4 der Lastzone 1 eine Sicherung 5 angeordnet. Die Spannung u_{Sx} über der Sicherung 5 wird von dem Spannungssensor 7 erfasst. Die erfassten Werte der Spannung über den jeweiligen Sicherungen 5 werden von den Spannungssensoren 7 an eine Auswerteeinheit 9 übertragen. Für den Fall, dass eine Anzahl n von elektrischen Geräten 4 in der Lastzone vorhanden sind, sind somit auch insgesamt die Anzahl n an Sicherungen 5 und damit auch die Anzahl n an Spannungssensoren 7 vorhanden. Bei der Bezeichnung der Spannung u_{Sx} handelt es sich um die Spannung an der x-ten Sicherung 5, wobei x dann einen Wert zwischen 1 und n annimmt. Als elektrische Geräte 4 sind in diesem Ausführungsbeispiel Wechselrichter 12 dargestellt, die jeweils einen Zwischenkreiskondensator 11 aufweisen. Als elektrische Geräte können aber auch alternativ jede Art eines elektrischen Verbrauchers und/oder eines Energiespeichers vorhanden sein.

Kommt es zu einem Kurzschluss in oder an einem der elektrischen Geräten 4, so speisen die Zwischenkreiskondensatoren 11 der übrigen elektrischen Geräte 4 in diesen Kurzschluss mit ein. Darüber hinaus kann auch weitere Energie aus den einzelnen Wechselrichtern 12 in diesen Kurzschluss eingespeist werden. Zur Trennung der Lastzone 1 von der Energiequelle 6 weist die Lastzone 1 einen elektronischen Schalter 2 auf, der zwischen den Anschlüssen 30 der Lastzone und dem DC-Bus 3 angeordnet ist. Mit diesem elektronischen Schalter 2 kann die Energieversorgung von der Energiequelle 6 an die elektrischen Geräte 4 der Lastzone 1 schnell unterbrochen werden.

Tritt in einem ersten elektrischen Gerät 41 ein Fehler, wie beispielsweise ein Kurzschluss auf, so führt dies aufgrund des Stroms von der Energiequelle 6 und den weiteren elektrischen Geräten 4 zu einem Auslösen der Sicherung 5 in der entsprechenden Verbindung zwischen dem ersten elektrischen Gerät 41 und dem DC-Bus 3. Durch das Auslösen der entsprechenden Sicherung 5 kann der Fehlerort am ersten elektrischen Gerät 41 zweifelsfrei lokalisiert werden.

Erkennt jedoch eine hier nicht näher beschriebene Schutzvorrichtung des DC-Netzes 10 oder der Lastzone 1 einen Fehler innerhalb dieser Lastzone 1, so kann als Reaktion darauf der elektronische Schalter 2 geöffnet werden, schon bevor die Sicherung 5 ausgelöst hat. In diesem Fall wird nach dem Öffnen des elektronischen Schalters 2 keine elektrische Energie von der Energiequelle 6 in den Kurzschluss des ersten elektrischen Gerätes 41 mehr gespeist. Lediglich die übrigen elektrischen Geräte 4 speisen Energie, beispielsweise aus den Zwischenkreiskondensatoren 11 und/oder der Wechselrichter 12 in den Kurzschluss des ersten elektrischen Gerätes 41. Dabei kann der entsprechende Strom durch die Sicherung 5 derart klein sein, dass die Sicherung 5 nicht mehr auslöst, sondern leitend bleibt. Das fehlerhafte erste elektrische Gerät ist in diesem Fall nicht mehr anhand des Zustands der Sicherung 5 erkennbar. Üblicherweise wird in diesem Fall heutzutage ein Stromsensor in Reihe zur Sicherung eingesetzt, um Ströme beispielsweise verursacht durch einen Kurzschluss detektieren zu können.

Um jedoch eine Lokalisierung des Fehlers auch ohne Stromsensor, d.h. stromsensorfrei, zu ermöglichen, wird jeweils die über der Sicherung 5 abfallende Spannung u_{Sx} für die einzelnen Sicherungen 5 der Lastzone 1 gemessen. Die Polarität der Messung durch den Spannungssensor 7 wird dabei so vorgenommen, dass eine elektrische Energie, die in das elektrische Gerät 4 fließt, als positive Spannung erfasst wird. Das elektrische Gerät 4, bei dem die höchste Spannung u_{Sx} gemessen wird, wird als das fehlerhafte elektrische Gerät erkannt. Es kann davon ausgegangen werden, dass der Fehler, insbesondere der Kurzschluss, bei diesem Gerät vorliegt. Durch die Verwendung der ohnehin erforderlichen Sicherung 5 als Art Messshunt eines Stromsensors ist kein zusätzliches Bauteil im Leistungspfad mehr erforderlich. Der Widerstandswert der Sicherung 5 ist im Gegensatz zu einem Messshunt eines Stromsensors zwar recht ungenau und einer großen Streuung über die verschiedenen Sicherungen 5 unterworfen. Allerdings ist es möglich, auch mit dieser großen Streuung/Ungenauigkeit beim Widerstand der Sicherungen 5 einen betrieblichen Strom von einem Strom im Fehlerfall zu unterscheiden. Allgemein werden an einen Messshunt hohe Anforderungen gerichtet, um eine entsprechend genaue Fehlererkennung und Fehlerlokalisierung vornehmen zu können. Es hat sich gezeigt, dass diese sonst üblichen Anforderungen an den Widerstand der Sicherung 5 nicht erfüllt werden müssen, um einen betrieblichen Strom von einem Fehlerstrom zuverlässig unterscheiden zu können. Damit werden auch keine zusätzlichen Verluste in der Zuleitung zwischen den DC-Netz 3 und dem elektrischen Gerät 4 erzeugt. Die Auswerteeinheit 9 kann anhand der von den Spannungssensoren 7 übermittelten Werte ermitteln, welches der elektrischen Geräte 4 fehlerhaft ist.

Wenn ein Fehler in der Lastzone 1 beispielsweise anhand eines Überstroms bereits erkannt wurde und der elektronische Schalter 2 bereits geöffnet ist, kann der Fehler innerhalb der Lastzone 1 dadurch genauer lokalisiert werden, dass die Spannungshöhe der über den jeweiligen Sicherungen 5 abfallenden Spannung u_{Sx} miteinander verglichen wird. Das elektrische Gerät, bei dem in der Verbindung zwischen dem elektrischen Gerät und den DC-Bus 3 die höchste Spannung u_{Sx} über der Sicherung 5 abfällt, wird als fehlerhaftes Gerät erkannt. Alternativ oder ergänzend ist es möglich, ein fehlerhaftes Gerät dadurch zu erkennen, dass die über der Sicherung 5 abfallende Spannung u_{Sx} einen vorgebbaren Grenzwert überschreitet. Durch das Überschreiten des Grenzwertes kann davon ausgegangen werden, dass ein Fehler in diesem Gerät und damit in der Lastzone 1 vorliegt. Das Erkennen des Fehlers kann von der Auswerteeinheit 9 optional auch dazu genutzt werden, wie in der FIG 1 gestrichelt dargestellt, den elektronischen Schalter 2 zu öffnen.

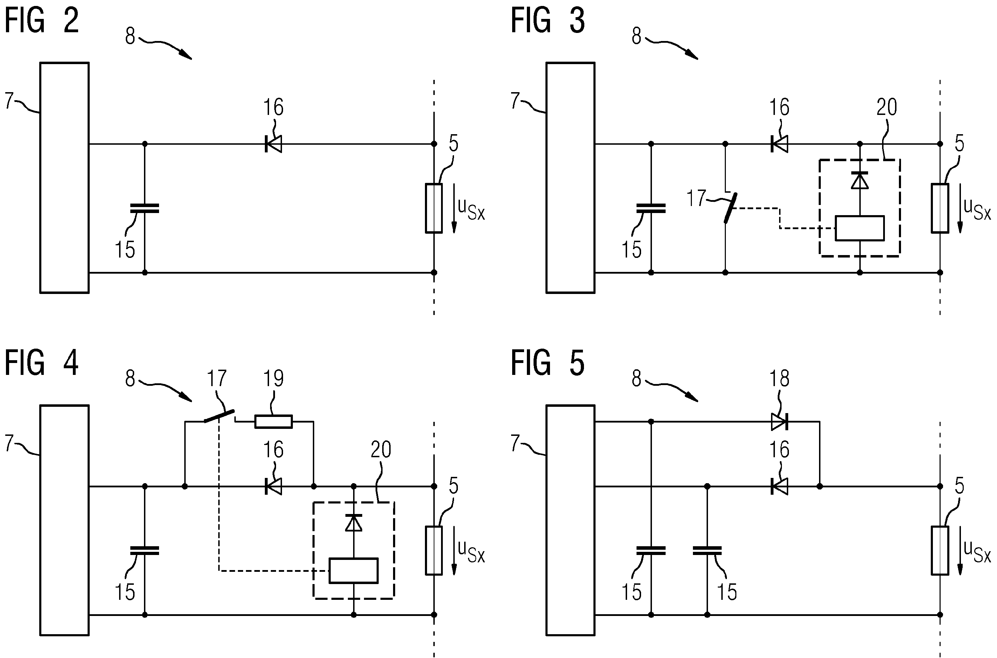

Darüber hinaus hat es sich als vorteilhaft erwiesen, die einzelnen Spannungen u_{Sx} die über den jeweiligen Sicherungen 5 abfallen, zu erfassen und zu speichern. Weiter hat es sich als vorteilhaft erwiesen, alternativ oder ergänzend, den Spitzenwert, der über der Sicherung 5 anliegenden Spannung u_{Sx} zu erfassen und zu speichern. Dabei kann der Spitzenwert beispielsweise über einen hier nicht dargestellten Spitzenwertgleichrichter 8 oder innerhalb der Datenverarbeitung, beispielsweise der Auswerteeinheit 9, bestimmt und gespeichert werden. Bei einem Spitzenwertgleichrichter 8 kann die Speicherung dadurch erfolgen, dass der Spitzenwert über einen Kondensator 15 dauerhaft anliegt. Dies wird im Folgenden in den Figuren 2 bis 5 näher beschrieben und erläutert. Durch die Kenntnis des Spitzenwertes kann die Lokalisierung des Fehlers durch Vergleich der Spitzenwerte der Spannungen u_{Sx} auch dann erfolgen, wenn schon kein oder nur zumindest ein geringer Kurzschlussstrom fließt.

Die FIG 2 zeigt ein Ausführungsbeispiel eines Spitzenwertgleichrichters 8. Mit diesem kann der Spitzenwert eine über der Sicherung 5 anliegenden Spannung u_{Sx} am Gleichrichtkondensator 15 erzeugt werden. Sobald die Spannung u_{Sx} über der Sicherung 5 größer ist als die Spannung am Gleichrichtkondensator 15, so wird der Gleichrichtkondensator 15 über die Diode 16 aufgeladen, bis auch die Spannung am Gleichrichtkondensator 15 die Spannung u_{Sx} über der Sicherung 5 erreicht hat. Sinkt die Spannung u_{Sx} über der Sicherung 5 wieder, so wird durch die Diode 16 ein Entladestrom des Gleichrichtkondensators 15 verhindert und der Spitzenwert der über der Sicherung 5 anliegenden Spannung u_{Sx} bleibt am Gleichrichtkondensator 15 bestehen. Dies entspricht einer Speicherung des Spitzenwertes der über der Sicherung 5 anliegenden Spannung u_{Sx}. Der Spannungssensor 7 kann dann den so gespeicherten Spitzenwert aufnehmen und an eine hier nicht dargestellte Auswerteeinheit 9 übertragen. In der Auswerteeinheit 9 kann dann die Bestimmung des fehlerhaften elektrischen Gerätes stattfinden.

Der Vorteil dieses Spitzenwertgleichrichters 8 besteht darin, dass nicht ständig Daten erfasst und/oder übermittelt werden müssen. Mit Auftreten eines Fehlers und/oder Erkennen eines Fehlers in der Lastzone 1 kann die Bestimmung in der Auswerteeinheit 9 stattfinden, da die entsprechenden Spitzenwerte als Spannung am Gleichrichtkondensator 15 auch nach Auftreten des Fehlers und Öffnen des elektronischen Schalters 2 der Auswerteeinheit zur Verfügung stehen oder durch den Spannungssensor 7 zur Verfügung gestellt werden können.

Die FIG 3 zeigt ein weiteres Ausführungsbeispiel des Spitzenwertgleichrichters 8. Zur Vermeidung von Wiederholungen wird auf die Beschreibung zur FIG 2 sowie auf die dort eingeführten Bezugszeichen verwiesen. Dieses Ausführungsbeispiel weist zusätzlich einen Schalter 17 auf, der von einer Polaritätserfassung 20 angesteuert wird. Nimmt die über der Sicherung 5 anliegenden Spannung u_{Sx} einen negativen Wert an, so erkennt dies die Polaritätserfassung 20 und schließt den Schalter 17. Der Gleichrichtkondensator 15 wird damit kurzgeschlossen und entladen. Die Spannung am Gleichrichtkondensator nimmt dabei den Wert null an. Somit wird der Spitzenwert, der am Gleichrichtkondensator anliegt und gespeichert wird zurückgesetzt. Alternativ ist es möglich, in Reihe zum Schalter 17 einen Widerstand anzuordnen. Mit dieser Anordnung wird dann der Kondensator kontinuierlich und nicht schlagartig entladen. Dies entspricht einer Reduzierung des gespeicherten Wertes.

Sobald die über der Sicherung 5 anliegende Spannung u_{Sx} positive Werte annimmt öffnet der Schalter 15 und am Gleichrichtkondensator liegt wieder der Spitzenwert der über der Sicherung 5 anliegenden Spannung u_{Sx} an, der sich seit dem Öffnen des Schalters 17 ergeben hat.

Der Schalter 17 kann Teil eines Schützes sein, wobei der Schalter 17 ein Schaltkontakt des Schützes ist und die die Spule des Schützes Teil der Polaritätserfassung 20 ist. Eine Diode der Polaritätserfassung 20 sorgt dafür, dass an der Spule des Schützes eine Spannung anliegt, sobald die über der Sicherung 5 anliegenden Spannung u_{Sx} negativ ist. Diese Spannung führt zum Ansprechen des Schützes bei dem der Schalter 17 geschlossen wird.

Die FIG 4 zeigt ein weiteres Ausführungsbeispiel des Spitzenwertgleichrichters 8. Zur Vermeidung von Wiederholungen wird auf die Beschreibung zur FIG 2 und zur FIG 3 sowie auf die dort eingeführten Bezugszeichen verwiesen. Dieses Ausführungsbeispiel weist ebenfalls den Schalter 17 und die Polaritätserfassung 20 auf. Dabei ist der Schalter 17 so angeordnet, dass bei einer negativen über der Sicherung 5 anliegenden Spannung u_{Sx} die Spannung am Gleichrichtkondensator 15 reduziert und nicht schlagartig entladen wird. Dabei ist in Reihe zum Schalter 17 ein Widerstand 19 angeordnet. Die Größe des Widerstandswertes des Widerstands 19 bestimmt dabei die Geschwindigkeit, mit der die Spannung am Gleichrichtkondensator 15 reduziert wird. Mit dem Reduzieren der Spannung am Gleichrichtkondensator 15 wird der gespeicherte Datenwert des Spitzenwertes reduziert.

Durch das Rücksetzen oder Reduzieren des gespeicherten Datenwertes für den Spitzenwert ist das fehlerhafte elektrische Gerät deutlich leichter erkennbar. Dies liegt darin, dass die nicht fehlerhaften elektrischen Geräte bei Auftreten eines Fehlers in der Lastzone oftmals Energie abgeben und deshalb an der Sicherung eine negative Spannung entsteht. Damit ist das fehlerhafte Gerät, bei dem eine positive Spannung zumindest im Fehleraugenblick anliegt, noch einfacher und zuverlässiger ermittelbar, da die ordnungsgemäß funktionierenden elektrischen Geräte zumindest teilweise eine negative Spannung u_{Sx} an ihrer zugeordneten Sicherung 5 aufweisen und den gespeicherten Datenwert dadurch reduzieren.

Die FIG 5 zeigt ein weiteres Ausführungsbeispiel des Spitzenwertgleichrichters 8. Zur Vermeidung von Wiederholungen wird auf die Beschreibung zu den Figuren 2 bis 4 sowie auf die dort eingeführten Bezugszeichen verwiesen. Dieses Ausführungsbeispiel weist keinen Schalter 17 und keine Polaritätserfassung 20 mehr auf. Bei diesem Spitzenwertgleichrichter 8 wird mit Hilfe der Diode 16 ein positiver Spitzenwert, analog zu den Ausführungsbeispielen der Figuren 2 bis 4 bestimmt und gespeichert. Darüber hinaus wird auch noch mit Hilfe einer weiteren Diode 18 ein negativer Spitzenwert bestimmt und als Spannung am zweiten Gleichrichtkondensator 15 gespeichert. Der negative Spitzenwert ist definiert als der betraglich größte Wert einer negativen Spannung. Dieser positive und negative Spitzenwert kann von der Spannungserfassung 7 jeweils erfasst und der Auswerteeinheit 9 zugeführt werden. Die Kenntnis über positiven und negativen Spitzenwert kann die Zuverlässigkeit bei der Bestimmung des fehlerhaften elektrischen Gerätes weiter erhöhen, da neben einem Vergleich der Datenwerte unterschiedlicher elektrischer Geräte auch für jedes elektrische Gerät ein positiver und ein negativer Spitzenwert vorliegt. Dabei kann als weiteres Kriterium für die Bestimmung des fehlerhaften elektrischen Gerätes der positive und der negative Spitzenwert miteinander verglichen werden.

## Patentansprüche

1. Lastzone (1), aufweisend
- einen elektronischen Schalter (2),
- einen DC-Bus (3),
- einen Anschluss (30) zur Versorgung der Lastzone (1) mit elektrischer Energie,
- mindestens zwei elektrische Geräte (4) und
- eine Sicherung (5),
wobei der elektronische Schalter (2) zwischen dem Anschluss (30) und dem DC-Bus (3) angeordnet ist, wobei die elektrischen Geräte (4) jeweils elektrisch parallel mit dem DC-Bus (3) verbunden sind, wobei zwischen dem DC-Bus (3) und dem jeweiligen elektrischen Gerät (4) die Sicherung (5) angeordnet ist,
**dadurch gekennzeichnet, dass** die Lastzone (1) ferner
- einen Spannungssensor (7) und
- eine Auswerteeinheit (9)
aufweist, wobei der Spannungssensor (7) derart angeordnet ist, eine über der Sicherung (5) anliegende Spannung (u_{Sx}) zu erfassen, wobei die Auswerteeinheit (9) eingerichtet ist, anhand der Polarität der über der Sicherung anliegenden und durch den Spannungssensor gemessenen Spannung die Bestimmung eines fehlerhaften Gerätes der elektrischen Geräte auszuführen.

2. Lastzone (1) nach Anspruch 1, wobei die Verbindung zwischen DC-Bus (3) und jeweiligem elektrischen Gerät (4) stromwandlerfrei ausgeführt ist.

3. Lastzone (1) nach einem der Ansprüche 1 oder 2, wobei ein Spitzenwert der über der Sicherung (5) anliegenden Spannung (u_{Sx}), insbesondere mittels eines zwischen der Sicherung (5) und dem Spannungssensor (7) angeordneten Spitzenwertgleichrichters (8), jeweils als gespeicherter Datenwert erfassbar und speicherbar ist, wobei bei Auftreten einer negativen über der Sicherung (5) anliegenden Spannung (u_{Sx}) der gespeicherte Datenwert reduzierbar, insbesondere rücksetzbar ist.

4. Lastzone (1) nach Anspruch 3, wobei ein weiterer Datenwert erfassbar und speicherbar ist, wobei der gespeicherte Datenwert zur Erfassung und Speicherung eines positiven Spitzenwertes und der weitere Datenwert zur Erfassung und Speicherung eines negativen Spitzenwertes bestimmt ist.

5. DC-Netz (10) mit einer Lastzone (1) nach einem der Ansprüche 1 bis 4 und mindestens einer Energiequelle (6), wobei die Energiequelle (6) mit dem Anschluss (30) der Lastzone (1) verbunden ist, insbesondere derart mit der Lastzone (1) verbunden ist, dass die elektrischen Geräte (4) mit elektrischer Energie aus der Energiequelle (6) versorgbar sind und dass mittels des elektronischen Schalters (2) die elektrische Verbindung zwischen der Energiequelle (6) und dem DC-Bus (3) unterbrechbar ist.

6. Verfahren zur Fehlerlokalisierung in einer Lastzone (1) nach einem der Ansprüche 1 bis 4 oder eines DC-Netzes (10) nach Anspruch 5, wobei die jeweiligen Spannungen (u_{Sx}) über den Sicherungen (5) der Lastzone (1) mittels des jeweiligen Spannungssensors (7) gemessen werden, wobei ein fehlerhaftes Gerät der elektrischen Geräte (4) anhand der Polaritäten der über der Sicherung (5) anliegenden Spannung (u_{Sx}) ermittelt wird.

7. Verfahren nach Anspruch 6, wobei das fehlerhafte Gerät dadurch erkannt wird, dass die über der Sicherung (5) anliegende Spannung einen vorgebbaren Grenzwert überschreitet.

8. Verfahren nach einem der Ansprüche 6 oder 7, wobei die Spannungshöhe der über den jeweiligen Sicherungen (5) abfallende Spannung (u_{Sx}) miteinander verglichen wird, wobei das elektrische Gerät, in dessen Verbindung zum DC-Bus an der Sicherung (5) die höchste Spannung (u_{Sx}) durch den Spannungssensor (7) gemessen wird oder gemessen wurde als fehlerhaftes Gerät ermittelt wird.

9. Verfahren nach einem der Ansprüche 6 bis 8, wobei bei oder nach Auftreten eines Fehlers in der Lastzone (1) das fehlerhafte Gerät dadurch ermittelt wird, dass der Spitzenwert der über der Sicherung (5) anliegenden Spannung (u_{Sx}) jeweils als gespeicherter Datenwert erfasst und gespeichert wird und die Ermittlung des fehlerhaften Gerätes in Abhängigkeit vom gespeicherter Datenwert erfolgt.

10. Verfahren nach Anspruch 9, wobei der höchste Spitzenwert aller gemessenen Spannungen herangezogen wird, um das fehlerhafte Gerät zu ermitteln, wobei das elektrische Gerät, in dessen Verbindung zum DC-Bus an der Sicherung (5) der höchste Spitzenwert durch den Spannungssensor (7) gemessen wird oder gemessen wurde als fehlerhaftes Gerät ermittelt wird.

11. Verfahren nach einem der Ansprüche 9 oder 10, wobei bei einer negativen, über der Sicherung (5) anliegende Spannung (u_{Sx}) der gespeicherte Datenwert reduziert, insbesondere zurückgesetzt, wird.

12. Verfahren nach einem der Ansprüche 9 bis 11, wobei als gespeicherter Datenwert der positive Spitzenwert erfasst und gespeichert wird, wobei ein weiterer Datenwert erfasst und gespeichert wird, der jeweils dem negativen Spitzenwert der über der Sicherung (5) anliegenden Spannung (u_{Sx}) entspricht.

13. Verfahren nach einem der Ansprüche 9 bis 12, wobei der Zeitpunkt des Auftretens des gespeicherten Datenwertes und/ oder des weiteren Datenwertes erfasst und gespeichert wird, wobei die Erkennung des fehlerhaften Gerätes in Abhängigkeit von den Zeitpunkten des gespeicherten Datenwertes und des weiteren Datenwertes erfolgt.

## Claims

1. Load zone (1) having
- an electronic switch (2),
- a DC bus (3),
- a connection interface (30) for supplying the load zone (1) with electrical energy,
- at least two electrical devices (4) and
- a fuse (5),
wherein the electronic switch (2) is arranged between the connection interface (30) and the DC bus (3), wherein the electrical devices (4) are each electrically connected in parallel to the DC bus (3), wherein the fuse (5) is arranged between the DC bus (3) and the respective electrical device (4),
**characterised in that** the load zone (1) furthermore has
- a voltage sensor (7) and
- an evaluation unit (9),
wherein the voltage sensor (7) is so arranged as to capture a voltage (u_{Sx}) across the fuse (5), wherein the evaluation unit (9) is configured to perform the determination of a defective device of the electrical devices on the basis of the polarity of the voltage across the fuse, said voltage being measured by the voltage sensor.

2. Load zone (1) according to claim 1, wherein the connection between DC bus (3) and respective electrical device (4) is embodied without a current transformer.

3. Load zone (1) according to one of claims 1 or 2, wherein a peak value of the voltage (u_{Sx}) across the fuse (5) can be captured and stored as a stored data value in each case, in particular by means of a peak value rectifier (8) that is arranged between the fuse (5) and the voltage sensor (7), wherein the stored data value can be reduced, in particular reset, if a negative voltage (u_{Sx}) occurs across the fuse (5).

4. Load zone (1) according to claim 3, wherein a further data value can be captured and stored, wherein the stored data value is determined for the purpose of capturing and storing a positive peak value and the further data value is determined for the purpose of capturing and storing a negative peak value.

5. DC system (10) comprising a load zone (1) according to one of claims 1 to 4 and at least one energy source (6), wherein the energy source (6) is connected to the connection interface (30) of the load zone (1), in particular is connected to the load zone (1) in such a way that the electrical devices (4) can be supplied with electrical energy from the energy source (6) and that by means of the electronic switch (2) the electrical connection between the energy source (6) and the DC bus (3) can be interrupted.

6. Method for fault localization in a load zone (1) according to one of claims 1 to 4, or a DC system (10) according to claim 5, wherein the respective voltages (u_{Sx}) across the fuses (5) of the load zone (1) are measured by means of the respective voltage sensor (7), wherein a defective device of the electrical devices (4) is identified on the basis of the polarities of the voltage (u_{Sx}) across the fuse (5).

7. Method according to claim 6, wherein the defective device is detected in that the voltage across the fuse (5) exceeds a specifiable limit value.

8. Method according to one of claims 6 or 7, wherein the voltage levels of the voltage (u_{Sx}) dropping across the respective fuses 5 are compared with each other, wherein the electrical device in whose connection to the DC bus the highest voltage (u_{Sx}) is or was measured at the fuse (5) by the voltage sensor (7) is identified as the defective device.

9. Method according to one of claims 6 to 8, wherein the defective device is identified when or after a fault occurs in the load zone (1) in that the peak value of the voltage (u_{Sx}) across the fuse (5) is captured and stored as a stored data value in each case and the identification of the defective device takes place as a function of the stored data value.

10. Method according to claim 9, wherein the highest peak value of all measured voltages is used to identify the defective device, wherein the electrical device in whose connection to the DC bus the highest peak value is or was measured at the fuse (5) by the voltage sensor (7) is identified as the defective device.

11. Method according to one of claims 9 or 10, wherein the stored data value is reduced, in particular reset, in the event of a negative voltage (u_{Sx}) across the fuse (5).

12. Method according to one of claims 9 to 11, wherein the positive peak value is captured and stored as a stored data value, wherein a further data value is captured and stored which corresponds in each case to the negative peak value of the voltage (u_{Sx}) across the fuse (5).

13. Method according to one of claims 9 to 12, wherein the time point of the occurrence of the stored data value and/or of the further data value is captured and stored, wherein the detection of the defective device takes place as a function of the time points of the stored data value and of the further data value.

## Revendications

1. Zone (1) de charge, comportant
- un interrupteur (2) électronique,
- un bus (3) à courant continu,
- une borne (30) d'alimentation de la zone (1) de charge en énergie électrique,
- au moins deux appareils (4) électriques et
- un fusible (5),
dans laquelle l'interrupteur (2) électronique est monté entre la borne (30) et le bus (3) à courant continu, dans laquelle les appareils (4) électriques sont montés respectivement électriquement en parallèle avec le bus (3) à courant continu, dans laquelle le fusible (5) est monté entre le bus (3) à courant continu et l'appareil (4) électrique respectif,
**caractérisée en ce que** la zone (1) de charge comporte en outre
- un capteur (7) de tension et
- une unité (9) d'évaluation,
dans laquelle le capteur (7) de tension est disposé de manière à détecter une tension (u_{Sx}) s'appliquant aux bornes du fusible (5), dans laquelle l'unité (9) d'évaluation est agencée pour effectuer, à l'aide de la polarité de la tension s'appliquant aux bornes du fusible et mesurée par le capteur de tension, la détermination d'un appareil défectueux des appareils électriques.

2. Zone (1) de charge suivant la revendication 1, dans laquelle la connexion entre le bus (3) à courant continu et l'appareil (4) électrique respectif est réalisée sans transformateur.

3. Zone (1) de charge suivant l'une des revendications 1 ou 2, dans laquelle une valeur de pointe de la tension (u_{Sx}) s'appliquant aux bornes du fusible (5) peut, en particulier au moyen d'un redresseur de valeur de pointe (8) monté entre le fusible (5) et le capteur (7) de tension, être détectée et mise en mémoire respectivement sous la forme d'une valeur de données mise en mémoire, dans laquelle, s'il apparaît une tension (u_{Sx}) négative s'appliquant aux bornes du fusible (5), la valeur de données mise en mémoire peut être réduite en étant, en particulier, remise à la valeur initiale.

4. Zone (1) de charge suivant la revendication 3, dans laquelle une autre valeur de données peut être détectée et mise en mémoire, dans laquelle la valeur de données mise en mémoire est déterminée pour la détection et la mise en mémoire d'une valeur de pointe positive et l'autre valeur de données pour la détection et la mise en mémoire d'une valeur de pointe négative.

5. Réseau (10) à courant continu, comprenant une zone (1) de charge suivant l'une des revendications 1 à 4 et au moins une source (6) d'énergie, dans lequel la source (6) d'énergie est connectée à la borne (30) de la zone (1) de charge en étant, en particulier, connectée à la zone (1) de charge, de manière à ce que les appareils (4) électriques puissent être alimentés en énergie électrique à partir de la source (6) d'énergie et de manière à pouvoir, au moyen de l'interrupteur (2) électrique, interrompre la connexion électrique entre la source (6) d'énergie et le bus (3) à courant continu.

6. Procédé de localisation de défauts dans une zone (1) de charge suivant l'une des revendications 1 à 4, ou dans un réseau (10) à courant continu suivant la revendication 5, dans lequel on mesure, au moyen du capteur (7) de tension respectif, les tensions (u_{Sx}) respectives aux bornes des fusibles (5) de la zone (1) de charge, dans lequel on détermine un appareil défectueux des appareils (4) électriques, à l'aide des polarités de la tension (u_{Sx}) s'appliquant aux bornes du fusible (5).

7. Procédé suivant la revendication 6, dans lequel on identifie l'appareil défectueux par le fait que la tension s'appliquant aux bornes du fusible (5) dépasse une valeur limite pouvant être donnée à l'avance.

8. Procédé suivant l'une des revendications 6 ou 7, dans lequel on compare entre elles la hauteur de la tension (u_{Sx}) chutant aux bornes des fusibles (5) respectifs, dans lequel on détermine comme appareil défectueux l'appareil électrique, dont on mesure ou on a mesuré, dans sa connexion au bus à courant continu, au fusible (5), la tension (u_{Sx}) la plus haute par le capteur (7) de tension.

9. Procédé suivant l'une des revendications 6 à 8, dans lequel, lors ou après l'apparition d'un défaut dans la zone (1) de charge, on détermine l'appareil défectueux, par le fait que l'on détecte et met en mémoire respectivement comme valeur de données mise en mémoire la valeur de pointe de la tension (u_{Sx}) s'appliquant aux bornes du fusible (5) et la détermination de l'appareil défectueux s'effectue en fonction de la valeur de données mise en mémoire.

10. Procédé suivant la revendication 9, dans lequel on tire parti de la valeur de pointe la plus haute de toutes les tensions mesurées, afin de déterminer l'appareil défectueux, dans lequel on détermine comme appareil défectueux l'appareil électrique, dont on mesure ou on a mesuré, dans sa connexion au bus à courant continu, au fusible (5) la valeur de pointe la plus haute par le capteur (7) de tension.

11. Procédé suivant l'une des revendications 9 ou 10, dans lequel, si la tension (u_{Sx}) s'appliquant aux bornes du fusible (5) est négative, on réduit la valeur de données mise en mémoire, en particulier en la remettant à l'état initial.

12. Procédé suivant l'une des revendications 9 à 11, dans lequel on détecte et on met en mémoire comme valeur de données mise en mémoire la valeur de pointe positive, dans lequel on détecte et on met en mémoire une autre valeur de données, qui correspond respectivement à la valeur de pointe négative de la tension (u_{Sx}) s'appliquant aux bornes du fusible (5).

13. Procédé suivant l'une des revendications 9 à 12, dans lequel on détecte et on met en mémoire l'instant de l'apparition de la valeur de données mise en mémoire et/ou de l'autre valeur de données, dans lequel l'identification de l'appareil défectueux s'effectue en fonction des instants de la valeur de données et de l'autre valeur de données mise en mémoire.
